Europäisches Patentamt

European Patent Office

Office européen des brevets

(11) Numéro de publication: **0 201 952**
**B1**

(12) **FASCICULE DE BREVET EUROPEEN**

(45) Date de publication du fascicule du brevet:
**19.09.90**

(51) Int. Cl.⁵: **G06K 19/06,** H01L 23/48

(21) Numéro de dépôt: **86200611.1**

(22) Date de dépôt: **10.04.86**

(54) **Procédé et dispositif pour fabriquer une carte d'identification électronique.**

(30) Priorité: **12.04.85 FR 8505518**

(43) Date de publication de la demande:
**20.11.86 Bulletin 86/47**

(45) Mention de la délivrance du brevet:
**19.09.90 Bulletin 90/38**

(84) Etats contractants désignés:
**CH DE FR GB IT LI SE**

(56) Documents cités:
**EP-A- 0 107 061**
**FR-A- 2 439 438**
**GB-A- 2 149 209**

(73) Titulaire: **PHILIPS COMPOSANTS, 117, quai du Président Roosevelt, F-92130 Issy les Moulineaux(FR)**
(84) Etats contractants désignés: **FR**

(73) Titulaire: **N.V. Philips' Gloeilampenfabrieken, Groenewoudseweg 1, NL-5621 BA Eindhoven(NL)**
(84) Etats contractants désignés: **CH DE GB IT LI SE**

(72) Inventeur: **Vieilledent, Gérard, 209 rue de l'Université, F-75007 Paris(FR)**

(74) Mandataire: **Caron, Jean et al, Société Civile S.P.I.D. 156, Boulevard Haussmann, F-75008 Paris(FR)**

## Description

L'invention concerne un procédé pour fabriquer une carte d'identification électronique selon lequel on monte au moins une pastille de circuit intégré sur un film porteur de pistes conductrices, que l'on découpe pour former une vignette supportant le circuit intégré, celui-ci étant recouvert d'un vernis de protection, la vignette étant ensuite mise en place, au moyen d'un ruban adhésif rollé sur le film, dans un logement ménagé dans une carte et dont la dimension correspond à celle de la vignette.

Elle concerne également un dispossitif pour fabriquer une carte d'identification, muni d'une bobine débitrice de film, d'un ensemble de montage et de câblage en continu de pastilles semiconductrices sur ledit film, d'une machine de découpage de vignettes dans ce film et de montage de ces vignettes dans des logements prévus dans des cartes d'identification, d'un appareil pour déposer du vernis et, en amont de l'ensemble de montage des pastilles, d'une bobine de ruban adhésif.

Les cartes d'identification fabriquées selon le procédé et avec le dispositif de l'invention sont utilisées dans des domaines variés où est requise l'utilisation d'un code secret et/ou d'une mémoire, tels que les cartes de paiement ou de crédit bancaire, les cartes d'identification médicales, carte d'identité, cartes d'accès à des locaux réservés, carte pour l'utilisation de téléphones publics, etc...

Le procédé de fabrication et le dispositif ci-dessus sont connus par exemple du document FR 2 439 438. Selon ce document on utilise un film sur lequel sont rapportés des pastilles de circuit intégré et dans lequel sont découpées ensuite des vignettes, par exemple circulaires, qui sont placées dans un logement en creux prévu à cet effet dans la carte.

Dans cette technique l'enrobage de la pastille pour assurer sa protection contre les agressions chimiques pose des problèmes. Soit on renonce à l'enrober comme dans le cas de la figure 3 du document cité, soit on est amené à ajouter un cadre spécial pour limiter l'étalement du produit d'enrobage, comme dans le cas de la figure 8 du même document, ce qui nécessite des opérations supplémentaires de fabrication.

L'invention a pour but de fournir un procédé et un dispositif qui permettent de réaliser un enrobage de la pastille de manière très simple et sans précautions particulières.

A cet effet, le procédé selon l'invention est notamment remarquable en ce qu'on utilise un ruban adhésif qui est recouvert d'une feuille de protection et muni d'au moins un trou traversant le ruban et la feuille de protection et au travers duquel on peut accéder à la pastille, mais qui est plus petit que le susdit logement ménagé dans la carte, en ce qu'après le montage de la pastille de circuit intégré, et avant la mise en place dans le logement de la carte, on dépose le vernis, du côté de la pastille, sur toute la surface accessible du film et du ruban, et on détache ensuite la feuille de protection, en enlevant donc avec elle le vernis qui la recouvre et mettant à nu le ruban adhésif, qui assure la fixation de la vignettelle dans la carte.

L'invention est donc basée sur l'idée de combiner deux effets dans l'utilisation de la feuille de protection, cette dernière servant d'épargne pour le vernis de protection en plus de son usage habituel d'anti-adhésif protégeant le ruban adhésif.

Le procédé selon l'invention peut être utilisé pour fabriquer des vignettes une par une, mais il est avantageusement mis en oeuvre dans une fabrication de grande série où le film porteur et le ruban adhésif avec sa feuille de protection sont chacun formés d'une bande de grande longueur issue d'une bobine. Dans ce cas le collage du ruban adhésif sur le film a lieu avantageusement avant le montage de la pastille de circuit intégré, le découpage du film pour former une vignette est avantageusement réalisé après que l'on ait détaché la feuille de protection, le découpage est effectué par un poinçon et ce même poinçon est utilisé pour appliquer la vignette dans le logement de la carte, où elle est dès lors fixée par le ruban adhésif. Afin d'éviter que, au moment du découpage de la vignette le film et le ruban qui n'ont plus de feuille de protection ne se collent de façon gênante sur la matrice associée au poinçon, il est avantageux qu'avant de procéder au découpage de la vignette, on applique sur le ruban adhésif une feuille de protection auxiliaire munie de trous d'une dimension et d'une forme pratiquement identiques à celles du logement dans la carte, et dont la position est choisie pour qu'un de ces trous soit en correspondance avec le logement dans la carte au moment où l'on procède au découpage et à la fixation de la vignette.

Pour la mise en oeuvre du procédé selon l'invention, un dispositif muni des éléments indiqués plus haut est en outre remarquable en ce que le ruban adhésif est couvert de deux feuilles de protection, et le dispositif est muni d'un outil pour créer dans ce ruban des trous qui sont plus petits que le logement d'une vignette dans une carte, d'un premier agencement pour décoller et recevoir une des feuilles de protection, de moyens de pression pour coller le ruban sur le film, et de moyens de repérage pour le positionnement relatif du film et du ruban, et en ce que l'appareil pour déposer du vernis est situé en aval de l'ensemble de montage de pastilles, le dispositif est muni d'un deuxième agencement pour décoller et recevoir la deuxième feuille de protection, d'un outil emporte pièce pour découper des vignettes dans le film et d'un système d'approvisionnement en cartes associé à cet outil emporte-pièce pour, en une seule opération, découper une vignette dans le film et la placer dans une carte, ou le ruban adhésif assure la fixation.

La description qui va suivre, en regard des dessins annexés décrivant des exemples non limitatifs fera bien comprendre comment l'invention peut être réalisée.

La figure 1 représente en perspective un film, un ruban, et une carte utilisées dans l'invention.

La figure 2 représente en coupe le long de l'axe longitudinal du film les constituants utilisés dans le procédé selon l'invention, à différents stades du procédé.

La figure 3 représente une vue en coupe au niveau de la vignette d'une carte réalisée selon le procédé, terminée.

La figure 4 représente un dispositif selon l'invention pour fabriquer des cartes.

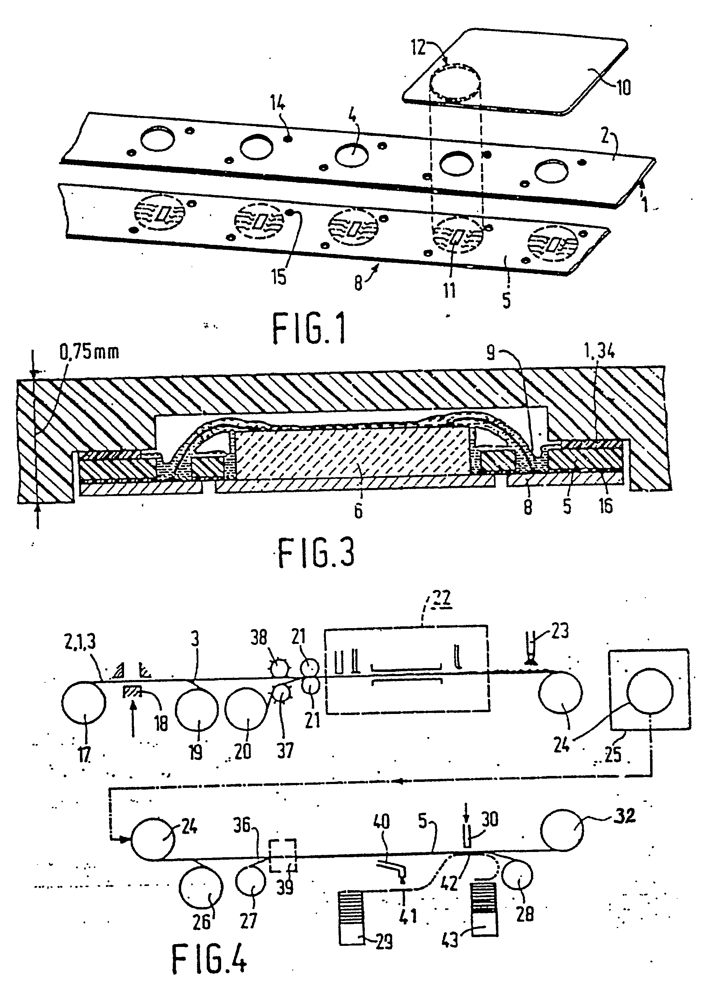

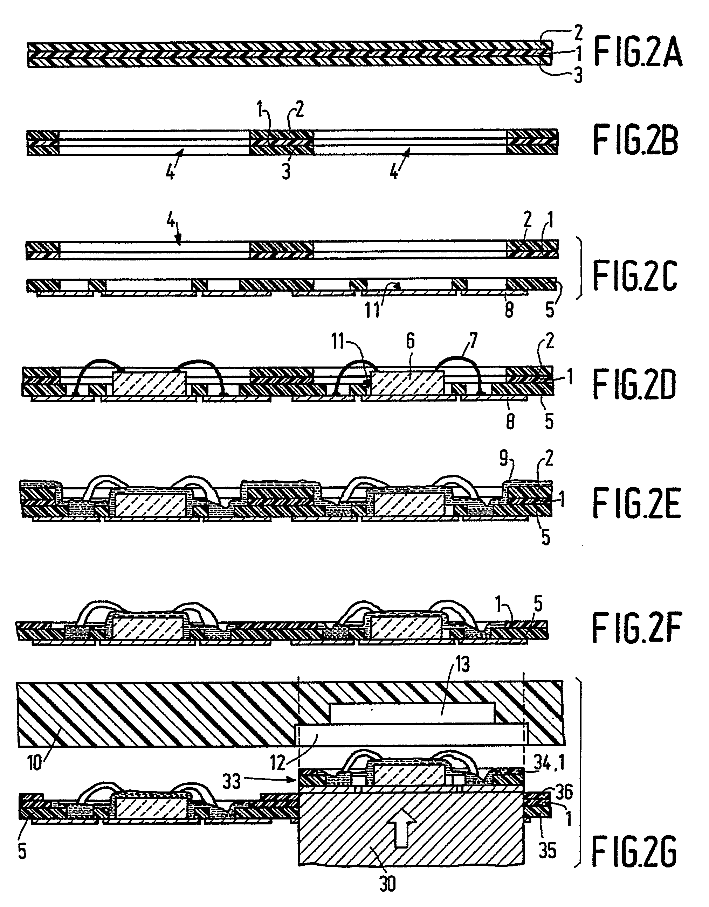

La figure 1 représente un film 5 tel qu'utilisé dans l'art antérieur. Ce film est muni de pistes imprimées 8 (visibles au travers du film) et des emplacements 11 y sont prévus pour le montage de circuits pastilles intégrés (fig. 2). Ce film n'est pas nécessairement muni de perforations de type "film cinéma", mais il doit cependant comporter au moins un trou de repérage 15 par emplacement de montage d'un circuit intégré.

Au-dessus du film 5 est représenté un ruban adhésif 1 muni d'une feuille de protection 2, par exemple en papier siliconé, qui recouvre la surface collante de ruban sans toutefois y adhérer fermement. Sur la figure la feuille 2 est au-dessus du ruban 1. Cet ensemble feuille-ruban a été préalablement percé de trous 4, dont on expliquera plus loin la dimension, et de trous 14 de repérage de position, qui correspondent aux trous 15 du film, et le ruban 1 est placé vis à vis du film 5 de façon qu'à chaque emplacement 11 de montage de circuit intégré (fig. 2) corresponde un trou 4. L'étape du procédé représentée par la figure 1 correspond à la figure 2c qui sera expliquée plus loin.

Bien qu'elle n'intervienne pas encore à ce stade du procédé, une carte 10 muni d'un logement 12 vu en transparence est représentée, afin d'indiquer les dimensions et positions relatives des différents éléments, sur lesquelles on reviendra plus loin.

La figure 2A représente en coupe un ruban adhésif 1 convenant à l'invention et muni de deux feuilles de protection 2, 3. Un tel ruban est vendu par exemple sous la référence Y9460 par la firme 3M.

Sur la figure 2B un trou 4 traversant le ruban et les feuilles de protection a été pratiqué dans le ruban.

Sur la figure 2C, la feuille de protection inférieure 3 a été enlevée et le ruban amené au-dessus d'un film 5 porteur de pistes conductrices 8. Le ruban avec la feuille de protection et le film sont tous deux avantageusement issus d'une bobine 17 (Fig. 4).

Sur la figure 2D le ruban a d'abord été collé sur le film et ensuite une pastille de circuit intégré 6 a été montée dans une cavité 11 du film, puis connectée aux pistes conductrices 8 de ce film au moyen de fils 7. Divers procédés de montage et de câblage du circuit intégré son bien connus de l'homme du métier, et décrits dans de nombreuses publications, parmi lesquelles on peut citer le brevet FR 2 439 438 déjà mentionné, ainsi que par exemple les brevets FR 2 548 857, EP 0116 148, FR 2 520 541.

La figure 2D montre en outre qu'au travers du trou du ruban 1, 2 on peut accéder à la pastille.

La figure 2E montre le film et le ruban recouverts d'un vernis 9 sur toute la surface du ruban et sur la surface du film accessible au travers du trou du ruban. Bien entendu la pastille de circuit intégré et ses fils de câblage sont, eux ainsi, recouverts de vernis, de manière à être protégés des atteintes chimiques qui pourraient les endommager dans l'avenir.

Le vernis utilisé est avantageusement un vernis polymérisable à base de silicone et d'une viscosité adaptée à son dépôt par pulvérisation. On peut utiliser par exemple le vernis vendu sous la référence commerciale "Electrofuge 200" de la marque Siceront KF. Il convient d'éviter les vernis polymérisables aux ultraviolets car ces derniers pourraient avoir des effets indésirables sur certains types de circuits intégrés.

La figure 2F montre le film et le ruban après qu'on ait détaché la feuille de protection 2, ce qui a pour effet de retirer aussi le vernis qui la recouvrait et de mettre à nu le ruban adhésif 1. Ainsi le vernis recouvrant la pastille et le film est bien délimité selon un périmètre qui est exactement celui du trou dans le ruban 1.

La figure 2G montre une partie d'une carte 10 qu'on a placée en face du film 5. Un poinçon ou emporte-pièce 30 a été représenté pour montrer comment, après que l'on ait détaché la feuille de protection, cet emporte-pièces découpe une vignette 33 dans le film et, en fin de course, vient l'appliquer dans le logement 12, 13 de la carte 10.

La dimension de la vignette découpée par l'emporte-pièce correspond à celle du logement dans la carte, c'est-à-dire qu'elle est, en fonction des diverses tolérences de fabrication, découpée de manière à rentrer le plus exactement possible dans le logement. Le logement dans la carte comporte une partie extérieure 12 et une partie centrale 13 plus profonde, dont l'effet sera expliqué plus en détail à propos de la figure 3.

Cette figure montre en outre que le trou du ruban adhésif est plus petit que le logement 12 ménagé dans la carte de sorte qu'après découpage de la vignette par l'emporte-pièce 30 il reste un anneau d'adhésif 34 sur la vignette, anneau adhésif qui assure la fixation de la vignette dans la carte. Cet effet du choix des diamètres dans le cas, par exemple de trous circulaires, est indiqué également par des lignes verticales interrompues sur la figure 1.

Sur la figure 2G, seul l'outil emporte-pièce 30 proprement dit a été représenté. Il peut être nécessaire d'adjoindre entre le film et la carte une matrice correspondant à l'outil 30, pour maintenir la partie de film inutilisée 35. L'homme de métier réalisera facilement les dispositions adéquates non représentées. En outre, la carte elle même peut servir de matrice, la partie 35 du film étant alors appliquée directement sur la carte ; il faut alors que les vignettes soient plus espacées que sur la figure de manière à ce qu'une seule vignette à la fois soit en regard de la carte.

Pour éviter que les parties inutilisées du film n'adhérent de façon gênante à la matrice ou à la carte, on a appliqué entre les étapes représentées par les figures 2F et 2G une feuille de protection auxiliaire 36 du même genre que les feuilles 2 et 3, munie de trous d'une dimension et d'une forme pratiquement identiques à celles du logement 12 dans la carte 10, et dont la position est choisie pour qu'un de ces trous soit en correspondance avec le logement dans la carte au moment où l'on procède au découpage et à la fixation de la vignette, de manière à ce qu'aucune partie de la feuille 36 ne soit découpée et introduite dans le logement 12.

La figure 3 qui représente une coupe dans une carte terminée permet de mettre en évidence les épaisseurs relatives des constituants. L'échelle des épaisseurs est environ 5 fois plus grande que l'échelle horizontale. La flèche verticale à gauche de la figure indique une épaisseur d'environ 0,75 mm.

Les différents éléments déjà décrits y sont représentés avec les mêmes références : le film 5 et ses métallisations 8, qui sont collées sous le film par une couche de colle 16, la pastille 6 qui, bien que montée dans une cavité du film, dépasse la surface de ce dernier, car le film a une épaisseur d'environ 150 micromètres (y compris la colle 16 mais non compris les métallisations 8 dont l'épaisseur est d'environ 70 micromètres) alors que la pastille 6 a une épaisseur d'environ 300 micromètres. L'adhésif 34 a une épaisseur de 50 micromètres, et le logement dans la carte 10 a, à l'extérieur, une profondeur de 300 micromètres là où vient adhérer l'anneau 34 d'adhésif déjà mentionné à propos de la figure 2G, et, au centre, une profondeur de 500 micromètres environ, pour permettre le logement de la pastille 6. Le vernis 9 doit avoir une épaisseur d'environ 10 à 50 micromètres, c'est-à-dire être moins épais que l'adhésif 34.

La figure 4 représente un dispositif pour mettre en oeuvre le procédé décrit ci-dessus. Ce dispositif comporte une bobine 17 débitrice de ruban adhésif protégé sur ses deux faces par une feuille de protection, par exemple en papier siliconé. Ce ruban avec ses feuilles de protection défile dans un outil emporte-pièce 18 qui y crée à intervalles réguliers les trous décrits plus hauts. Ensuite une bobine 19 entraînée en rotation tire sur la première feuille 3 de protection pour la décoller et la recueillir. Au lieu d'être enroulée sur une bobine, cette feuille pourrait d'ailleurs aussi bien tomber directement dans une poubelle. On pourrait par exemple prévoir alors un ensemble galet/cabestan pour tirer sur la feuille avant de la libérer. Une bobine 20 débite le film muni de métallisations et d'emplacements pour y monter une pastille de circuit intégré 6 (Fig. 1 & 3). Ce film suit, à la sortie de la bobine, un chemin identique à celui du ruban adhésif et ils sont collés l'un sur l'autre par un couple de rouleaux presseurs 21. Avant que les films ne soient appliqués l'une sur l'autre, ils sont guidés chacun par une roue 37, 38 munie d'ergots représentés symboliquement et qui s'engagent respectivement dans les perforations 15 du film et 14 du ruban adhésif (voir figure 1)Ces deux roues sont couplées en rotation entre elles pour assurer la correspondance · des perforations entre le film et le ruban (positionnement relatif).

A la sortie des rouleaux presseurs 21, lefilm recouvert du ruban adhésif avec sa feuille de protection passe dans un ensemble 22 de montage et de câblage de pastilles de circuit intégré. Ce dispositif est bien connu et ne fait pas partie de l'invention, c'est pourquoi on y a représenté seulement très schématiquement et sans numéro individuel de référence, de la gauche vers la droite, un outil de dépôt de colle, une pipette de montage de pastille, un four à passage pour le séchage de la colle et un outil de câblage de fils. Tel qu'est représenté l'ensemble du dispositif, les pastilles sont montées sur le dessus du film, ainsi qu'il est habituel.

A la sortie de l'ensemble de montage 22, le film passe devant une buse de pulvérisation de vernis 23. Cette buse est réglée de façon à obtenir une épaisseur d'environ 30 microns de vernis. On pourrait aussi faire faire une boucle vers le bas au film pour le tremper au passage dans un bain de vernis. Toutefois, ce procédé est moins intéressant car il exige de prévoir préalablement une protection du dos du film, ce qui complique le procédé.

Après le dépôt du vernis on enroule le film sur une bobine 24, en interposant une couche intercalaire d'espacement entre les spires, et on place ensuite la bobine entière dans une étuve 25, pour sécher et/ou polymériser le vernis.

La bobine est ensuite reprise, éventuellement après un stockage, et une autre partie du dispositif qui peut être située en un tout autre lieu que la première puisque les bobines vernies peuvent être tranportées sans risque de détérioration, est équipée d'un support pour ladite bobine 24, d'une bobine 26 pour décoller et recevoir la deuxième feuille de protection. Cette bobine fonctionne comme la bobine 19 précédemment décrite, et peut comme elle être remplacée par d'autres systèmes équivalents. Un système d'approvisionnement en cartes est muni par exemple d'un magasin chargeur de cartes 29. Un système connu de manutention des cartes (non représenté) amène les cartes depuis le chargeur 29 en suivant le trajet indiqué en pointillé et présente une carte en face d'une vignette dans la position 42 (la position relative carte/vignette correspond à celle de la figure 2G, mais la tête en bas). Enfin, un outil emporte-pièce 30 découpe la vignette dans le film, et, en fin de course place cette vignette dans le logement de la carte, où elle se colle grâce à l'anneau adhésif (34, 1, Fig 2 G et 3).

Entre le chargeur 29 et la position 42 est disposée une pipette doseuse automatique 40 qui a pour fonction de de déposer dans le logement 13 de la carte, bien entendu situé dans la face supérieure de cette dernière, une quantité déterminée, par exemple environ 30 milligrammes, d'un produit d'enrobage, par exemple les produits connus sous les références commerciales STYCAST 2850 FT et CATALYST 24 LV de la marque Emerson-Cuming, mélangés dans les proportions respectives 100/7. Enfin le système de manutenation retourne la carte après la pose de la vignette et la range dans un chargeur de produits finis 43.

En retournant la carte, le produit d'enrobage qui était dans le fond du logement coule sur la pastille de circuit intégré, mais est maintenu dans le logement puisque ce dernier est obstrué par la vignette. Bien que le produit cité puisse polymériser à l'ambiante, il est préférable de chauffer les cartes terminées à 60° C pendant deux heures pour améliorer les caractéristiques mécaniques du produit d'enrobage. Grâce à ce dernier la tenue en flexions répétées des cartes est nettement améliorée, car le vernis déposé auparavant est, lui, d'un genre qui reste souple et n'a pas d'action mécanique lors de la flexion des cartes.

Le dispositif est muni en outre, en amont du dispositif de placement de la vignette, d'une bobine 27 débitrice de la feuille de protection auxiliaire 36 mentionnée plus haut, percée à l'avance, et de moyens de repérage et de pression 39 pour positionner l'un par rapport à l'autre cette feuille et le film de la façon décrite plus haut, et appliquer la feuille sur le ruban, moyens semblables aux moyens 37, 38, 21. En aval du dispositif 29, 30 est présente une bobine 32 ou un dispositif quelconque pour recevoir les restes du film et du ruban muni de sa feuille protectrice 36. Maintenant que les vignettes ont été détachées et montées, il n'est plus utile de détacher le film protecteur 36 et on peut mettre l'ensemble des restes de film, de ruban et de feuille à la poubelle. Toutefois, si l'on veut réutiliser la feuille protectrice 36 issue de la bobine 27, ce qui est tout à fait possible puisqu'on ne lui fait subir aucune opération la modifiant, on prévoiera un agencement 28 identique aux précédents agencements 19 ou 26.

Différentes variantes ou équivalents sont possibles sans sortir du cadre de l'invention. Par exemple on pourrait monter les pastilles de circuit intégré avant d'amener et de coller le ruban adhésif. Toutefois, l'épaisseur de la pastille que dépasse la surface du film empêcherait d'utiliser des rouleaux lisses en 21. Il faudrait alors des rouleaux munis de cavités à l'endroit des pastilles, rouleaux eux mêmes reliés aux roues à ergots 37, 38 pour assurer la correspondance de la position des cavités vis à vis du film. De même l'ensemble de l'installation peut comporter plusieurs films en parallèle et le chargeur 29 contenir des plaques de grande taille comportant une pluralité de cartes élémentaires et sur lesquelles plusieurs films à la fois déposent ensemble une vignette par carte. Le chargeur 29 de cartes peut être remplacé par une bobine sur laquelle est enroulé un support auquel sont fixées à intervalles réguliers des cartes.

**Revendications**

1. Procédé pour fabriquer une carte d'identification électronique selon lequel on monte au moins une pastille de circuit intégré (6) sur un film (5) porteur de pistes conductrices (8), que l'on découpe pour former une vignette supportant le circuit intégré, celui-ci étant recouvertent d'un vernis de protection, la vignette étant ensuite mise en place, au moyen d'un ruban adhésif collé sur le film, dans un logement (12) ménagé dans une carte (10) et dont la dimension correspond à celle de la vignette, caractérisé en ce qu'on utilise un ruban adhésif qui est recouvert d'une feuille de protection (2) et muni d'au moins un trou (4) traversant le ruban et la feuille de protection, et au travers duquel on peut accéder à la pastille, mais qui est plus petit que le ledit logement (12) ménagé dans la carte, en ce qu'après le montage de la pastille de circuit intégré, et avant la mise en place dans le logement de la carte, on dépose le vernis, du côté de la pastille, sur toute la surface accessible de la pastille, du film et du ruban, et on détache ensuite la feuille de protection (2), en enlevant donc avec elle le vernis qui la recouvre et mettant à nu le ruban adhésif (1), qui assure la fixation de la vignette dans la carte.

2. Procédé selon la revendication 1, caractérisé en ce que le film porteur (5) et le ruban adhésif (1) avec sa feuille de protection (2) sont chacun formés d'une bande de grande longueur issue d'une bobine.

3. Procédé selon la revendication 2, caractérisé en ce que le découpage du film pour former une vignette est réalisé après que l'on ait détaché la feuille de protection (2), et en ce que le découpage est effectué par un poinçon (30) et en ce que ce même poinçon est utilisé pour appliquer la vignette (33) dans le logement (12, 13) de la carte, ou elle est dès lors fixée par le ruban adhésif (34).

4. Procédé selon la revendication 3, caractérisé en ce qu'avant de procéder au découpage de la vignette, on applique sur le ruban adhésif une feuille de protection auxiliaire (36) munie de trous d'une dimension et d'une forme pratiquement identiques à celles du logement (12) dans la carte, et dont la position est choisie pour qu'un de ces trous soit en correspondance avec le logement dans la carte au moment où l'on procède au découpage et à la fixation de la vignette.

5. Procédé selon l'une quelconque des revendications précédentes, caractérisé en ce que le collage du ruban adhésif (1) sur le film (5) a lieu avant le montage de la pastille de circuit intégré.

6. Procédé selon l'une quelconque des revendications précédentes, caractérisé en ce que le vernis (9) est un vernis polymérisable déposé par pulvérisation.

7. Procédé selon les revendications 2 et 6 ensemble, caractérisé en ce que pour polymériser le vernis on enroule le film sur une bobine (24) et en ce qu'on place cette bobine dans une étuve (25).

8. Dispositif pour fabriquer une carte d'identification muni d'une bobine (20) débitrice de film, d'un ensemble (22) de montage et de cablage en continu de pastilles semiconductrices sur ledit film, d'une machine (30) de découpage de vignettes dans ce film et de montage de ces vignettes dans des logements prévus dans des cartes d'identification, d'un appareil (23) pour déposer du vernis et, en amont de l'ensemble (22) de montage de pastilles, d'une bobine (17) de ruban adhésif, caractérisé en ce que ce dernier est recouvert d'au moins une feuille de protection, et le dispositif est muni d'un outil (18) pour créer dans ce ruban des trous qui sont plus petits que le logement d'une vignette dans une carte, de moyens de pression (21) pour coller le ruban sur le film, et de moyens de repérage (37, 38) pour le positionnement relatif du film et du ruban, en ce que l'appareil pour déposer du vernis est situé en aval de l'ensemble (22) de montage de pastilles, le dispositif est muni d'un agencement (26) pour décoller et recevoir la feuille de protection, et la machine de découpage de vignettes est munie d'un outil emporte-pièce (30) pour découper des vignettes dans le film associé à un système (29) d'approvisionnement en cartes pour, en une seule opération, découper une vignette dans le film et la placer dans une carte, où le ruban adhésif assure la fixation.

9. Dispositif selon la revendication 8 caractérisé en ce qu'il est muni, en aval de l'appareil pour déposer du vernis, d'une bobine (24) pour enrouler le film et d'une étuve (25) pour placer cette bobine.

10. Dispositif selon l'une des revendication 8 ou 9, caractérisé en ce qu'il est muni en outre, en amont du dispositif de placement de la vignette dans la carte, d'une bobine (27) débitant une feuille de protection percée auxiliaire (36), de moyens (39) de repérage pour assurer le positionnement relatif de cette feuille et du film et pour appliquer cette feuille sur le ruban.

11. Dispositif selon l'une quelconque des revendications 8 à 10, muni d'un système de manutention automatique des cartes, ces dernières étant munies d'un logement pour la pastille, caractérisé en ce que ce système présente les cartes en dessous du film (5) et de l'outil emporte pièce (30), en ce qu'il est muni, en amont du dispositif de placement de la vignette dans la carte, d'un moyen (40) pour déposer une quantité déterminée de produit d'enrobage dans le logement de la carte, et, en aval de ce même dispositif, de moyens (42, 43) pour retourner la carte.

## Claims

1. A method of manufacturing an electronic identification card, in which at least one integrated circuit chip (6) is mounted on a film (5) carrying conductor tracks (8), which is cut to form a vignette supporting the integrated circuit chip, which is covered with a protective varnish, this vignette then being arranged in a recess (12) by means of an adhesive tape stuck to the film, which recess is provided in a card (10) and whose dimension corresponds to that of the vignette, characterized in that an adhesive tape is used, which is covered with a protective layer (2) and provided with at least one hole (4) passing through the tape and the protective layer and through which the integrated circuit chip is accessible, but which is smaller than the aforementioned recess (12) provided in the card and in that, after the integrated circuit chip has been mounted and before it is arranged in the recess of the card, varnish is provided on the side of the chip over the whole accessible surface of the integrated circuit chip, of the film and of the tape in order to protect the chip, after which the protective layer (2) is detached thus lifting off with it the varnish covering it and exposing the adhesive tape (1), which ensures the fixation of the vignette in the card.

2. A method as claimed in Claim 1, characterized in that the carrier film (5) and the adhesive tape (1) with its protective layer (2) are each formed from a tape of substantial length supplied from a spool.

3. A method as claimed in Claim 2, characterized in that the operation of cutting the film to form a vignette is carried out after the protective layer (2) has been detached, in that the cutting operation is effected by a punch, and in that the same punch (30) is used for arranging the vignette (33) in the recess (12, 13) of the card, in which it is then fixed by the adhesive tape (34).

4. A method as claimed in Claim 3, characterized in that, before the vignette is cut, an auxiliary protective layer (36) is applied to the adhesive tape, this layer being provided with holes having a dimension and a shape practically identical to those of the recess (12) in the card and whose position is chosen so that one of these holes corresponds to the recess in the card at the instant at which the vignette is cut and fixed.

5. A method as claimed in any one of the preceding Claims, characterized in that the adhesive tape (1) is glued on the film (5) before the integrated circuit chip is mounted.

6. A method as claimed in any one of the preceding Claims, characterized in that the varnish (9) is a polymerizable varnish deposited by pulverization.

7. A method as claimed in the assembly of Claims 2 and 6, characterized in that, for polymerizing the varnish, the film is wound onto a spool and in that this spool (24) is arranged in a drying oven (25).

8. An arrangement for manufacturing an identification card provided with a film-supplying spool (20), with an assembly (22) for mounting and electrically connecting integrated circuit chips on the said film, with a machine (30) for cutting vignettes in the said film and for mounting these vignettes in recesses provided in identification cards, with a device (23) for depositing varnish and, upstream of the assembly (21) for mounting chips, with a spool (17) of adhesive tape, characterized in that the said tape is covered with at least one protective layer, and in that the arrangement is provided with a tool (18) for forming in this tape holes which are smaller than the recess of a vignette in a card, with pressure means (21) for gluing the tape on the film, and with calibration means (37, 38) for the relative positioning of the film and the tape, downstream of the assembly for mounting chips, the arrangement is provided with an apparatus (26) for detaching and receiving the protective layer, and in that the machine for cutting vignettes is provided with a punching tool (30) for cutting vignettes in the film associated with a card feed system (29) for cutting in a single operation a vignette in the film and arranging it in a card, where the adhesive tape ensures its fixation.

9. An arrangement as claimed in Claim 8, characterized in that it is provided, downstream of the apparatus for depositing varnish, with a spool (24) for winding the film and with a drying oven (25) for receiving this spool.

10. An arrangement as claimed in any one of Claims 8 or 9, characterized in that it is provided moreover, downstream of the apparatus for arranging the vignette in the card, with a spool (27) supplying a perforated auxiliary protective layer (36), with calibration means (39) for ensuring the relative positioning of this layer and the film and for applying this layer to the tape.

11. An arrangement as claimed in any one of Claims 8 to 10, provided with an automatic card-handling system, these cards being provided with a recess for the chip, characterized in that this system presents the cards below the film (5) and the punching tool (30), and in that it is provided, upstream of the device for placing the vignette in the card, with a means (40) for depositing a given quantity of coating material in the recess of the card and, downstream of the same device, with means (42, 43) for returning the card.

**Patentansprüche**

1. Verfahren zur Herstellung einer elektronischen Ausweiskarte, bei dem wenigstens eine Integrationsschaltungstablette (6) auf einer Trägerfolie (5) mit Leitspuren (87) angebracht wird, der zur Bildung einer Marke zur Unterstützung der integrierten Schaltung ausgeschnitten wird, die mit einem Schutzlack überzogen wird, wobei die Marke mit Hilfe eines auf der Trägerfolie angebrachten Klebebandes in einem Aufnahmeraum (12) in einer Karte (10) an ihren Platz gebracht wird, wobei die Raumabmessungen denen der Marke entsprechen, dadurch gekennzeichnet, daß ein Klebeband verwendet wird, das mit einer Schutzfolie (2) überzogen ist und wenigstens ein Loch (4) durch Band und Schutzfolie besitzt, wobei die Tablette durch das Loch erreichbar ist, dessen Abmessungen aber kleiner sind als die des Aufnahmeraums (12) in der Karte, und daß nach dem Anbringen der Integrationsschaltungstablette und vor dem Einführen der Marke in den Aufnahmeraum der Karte der Lack von der Tablettenseite her auf die ganze erreichbare Oberfläche der Tablette, der Trägerfolie und des Bandes aufgetragen wird, und daß anschließend die Schutzfolie (2) gelöst und gleichzeitig die Lackbeschichtung der Schutzfolie entfernt wird, wodurch das nackte Klebeband (1) zurückbleibt, das für die Befestigung der Marke in der Karte sorgt.

2. Verfahren nach Anspruch 1, dadurch gekennzeichnet, daß sowohl die Trägerfolie (5) als auch das Klebeband (1) mit seiner Schutzfolie (2) aus einem Band mit großer Länge hergestellt und von einer Vorratsspule abgewickelt werden.

3. Verfahren nach Anspruch 2, dadurch gekennzeichnet, daß das Ausschneiden der Trägerfolie zur Bildung einer Marke nach dem Lösen der Schutzfolie (2) erfolgt, daß das Ausschneiden mit Hilfe eines Lochers geschieht, und daß dieser Locher (30) zum Einführen der Marke (33) in den Aufnahmeraum (12, 13) der Karte benutzt wird, in dem sie danach mit dem Klebeband (34) befestigt wird.

4. Verfahren nach Anspruch 3, dadurch gekennzeichnet, daß vor dem Ausschneiden der Marke auf dem Klebeband eine Hilfs-Schutzfolie (36) mit Löchern angebracht wird, deren Abmessungen und Form nahezu gleich denen des Aufnahmeraums (12) in der Karte sind, und deren Lage derart gewählt wird, daß eines dieser Löcher mit der Lage des Aufnahmeraums in der Karte zum Zeitpunkt des Ausschneidens und Befestigens der Marke übereinstimmt.

5. Verfahren nach einem oder mehreren der vorangehenden Ansprüche, dadurch gekennzeichnet, daß das Verkleben des Klebebandes (1) mit der Trägerfolie (5) vor dem Anbringen der Integrationsschaltungstablette erfolgt.

6. Verfahren nach einem oder mehreren der vorangehenden Ansprüche, dadurch gekennzeichnet, daß der Lack (9) ein durch Zerstäubung niedergeschlagener polymerisierbarer Lack ist.

7. Verfahren nach den beiden Ansprüchen 2 und 6, dadurch gekennzeichnet, daß zum Polymerisieren des Lacks der Film auf eine Vorratsspule aufgewickelt und diese Spule (24) in einem Ofen (25) aufgestellt wird.

8. Vorrichtung zum Herstellen einer Ausweiskarte mit einer Trägerfolievorratsspule (20), einer Einheit (22) zum ununterbrochenen Anbringen und Verbinden von Halbleitertabletten auf der Trägerfolie, einer Maschine (30) zum Ausschneiden von Marken und zum Einführen dieser Marken in die in den Ausweiskarten ausgenommenen Aufnahmeräume, einem Apparat (23) zur Lackbeschichtung, und mit einer Klebebandvorratsspule (17) oberhalb der Einheit (22) zum Anbringen von Tabletten, dadurch gekennzeichnet, daß das Klebeband mit wenigstens einer Schutzfolie bedeckt ist, und daß die Vorrichtung mit einem Werkzeug (18) zum Durchlöchern dieses Klebebands, wobei diese Löcher kleiner sind als der Aufnahmeraum für eine Marke in der Karte, mit Andruckmitteln (21) zum Verkleben des Bandes auf der Trägerfolie und mit Mitteln (37, 38) zum Bestimmen der relativen Lage der Trägerfolie und des Bandes ausgerüstet ist, daß der Apparat zum Niederschlagen der Lackschicht sich unterhalb der Einheit (22) zum Einführen der Tabletten befindet, die Vorrichtung weiter eine Einrichtung zum Abstreifen und Aufnehmen der Schutzfolie besitzt, und daß die Markenausschneidemaschine mit einem Lochstanzwerkzeug (30) zum Markenausschneiden aus der Trägerfolie versehen ist, der mit einem Kartenzufuhrsystem zusammenarbeitet, um in einer einzigen Handlung eine Marke aus der Trägerfolie herauszuschneiden und sie in einer Karte anzubringen, in der das Klebeband die Befestigung versorgt.

9. Vorrichtung nach Anspruch 8, dadurch gekennzeichnet, daß sie unterhalb des Apparats zur Lackbeschichtung mit einer Spule (24) zum Aufwickeln der Trägerfolie und mit einem Ofen (25) zum Aufnehmen dieser Spule versehen ist.

10. Vorrichtung nach einem der Ansprüche 8 oder 9, dadurch gekennzeichnet, daß sie außerdem oberhalb der Einrichtung zum Einführen der Marke in die Karte mit einer Vorratsspule (27) zur Lieferung einer zusätzlich durchlöcherten Schutzfolie (36), und mit Mitteln zur Lagebestimmung zur Gewährleistung der relativen Lage dieser Schutzfolie und der Trägerfolie und zum Anbringen dieser Schutzfolie auf dem Band versehen ist.

11. Vorrichtung nach einem der Ansprüche 8 bis 10, mit einem Kartenvorschubautomaten, wobei diese Karten mit einem Tablettenaufnahmeraum versehen sind, dadurch gekennzeichnet, daß dieses System die Karten unter der Trägerfolie (5) und dem Lochstanzwerkzeug zuführt, daß es oberhalb der Einrichtung zum Einführen der Marke in die Karte mit einem Mittel (40) zum Anbringen einer bestimmten Menge eines Verkleidungsprodukts im Aufnahmeraum der Karte und unterhalb dieser Einrichtung mit Mitteln (42, 43) zum Zurückführen der Karte versehen ist.

FIG.1

0,75mm

FIG.3

FIG.4

FIG.2A

FIG.2B

FIG.2C

FIG.2D

FIG.2E

FIG.2F

FIG.2G